# EUROPEAN PATENT SPECIFICATION

(11) **EP 2 571 161 B1**
(45) Date of publication and mention of the grant of the patent: **21.03.2018**
(21) Application number: 11780398.1
(22) Date of filing: 13.05.2011
(51) Int. Cl.: H03F 1/34, H03F 1/02, H03F 1/32, H03F 3/181, H03F 3/217, H03F 3/183

(54) **AMPLIFIER**
VERSTÄRKER
AMPLIFICATEUR

(30) Priority: 26.07.2010 JP 2010166759; 14.05.2010 JP 2010111726
(43) Date of publication of application: 20.03.2013
(73) Proprietor: Panasonic Intellectual Property Management Co., Ltd., Osaka-shi, Osaka 540-6207 (JP)
(72) Inventor: OZAKI, Seigo, Osaka 540-6207 (JP); SUKEGAWA, Rintaro, Osaka 540-6207 (JP)
(74) Representative: Eisenführ Speiser
(86) International application number: PCT/JP2011/002674
(87) International publication number: WO 2011/142139

(56) References cited:
- EP-A1- 0 998 030
- WO-A1-2005/107061
- WO-A1-2009/019459
- WO-A2-2007/149346
- DE-A1- 19 858 963
- JP-A- 7 074 548
- JP-A- 2006 025 029
- JP-A- 2009 177 640
- US-A- 5 510 753
- US-A1- 2005 122 183
- US-A1- 2008 012 638
- US-A1- 2009 220 110
- US-A1- 2010 014 694

## Description

### Technical Field

The present invention relates to an amplifier that amplifies the power of an input signal, and more particularly, to an amplifier that performs a source voltage control of a supply power source at a power amplifier stage of a signal.

### Background Art

Conventionally, techniques of using a voltage-variable power source as a power source of an amplifier so as to reduce the noise superimposed on an output signal and to improve the power efficiency of the power source by changing a source voltage value supplied to a power amplifier stage to follow an input signal to an amplifier have been known.

By changing the source voltage supplied to the power amplifier stage to follow the input signal level, the source voltage of the power amplifier stage can be lowered to a voltage value of an amplitude to such an extent that an amplified signal is not distorted, when an input signal has small power. Accordingly, it is possible to reduce noise superimposed on an output signal of the amplifier and thus to improve the power efficiency of a power source.

In the case of an amplifier for a vehicle, since the installation space of the amplifier or the battery capacity is limited, a decrease in size and weight and a decrease in power consumption are desirable. When the power efficiency of the amplifier increases, it is possible to reduce the size or the number of components such as a heat sink necessary for heat radiation of ineffective power and it is also possible to suppress the power consumption of the amplifier. Accordingly, high power efficiency in an amplifier for a vehicle provides great merits.

Conventionally, a voltage-variable power source in which a voltage source supplies a first drive voltage component following the amplified absolute value of an input reference was disclosed (for example, see JP-T-2007-508731).

A power amplifier is disclosed in which a digital buffer stores a copy of an input signal indicating a predetermined time interval and an envelope profiler analyzes the buffered interval of the input signal and determines a supply signal profile suitable for the amplifier during the predetermined time interval (for example, see JP-T-2007-511187).

WO 2005/107061 A1 discloses an audio amplifier that includes an input terminal for receiving an input signal, an output terminal, a regulator reference generator coupled to the input terminal, wherein the regulator reference generator provides a voltage regulator reference corresponding to the input signal; a voltage regulator coupled to the regulator reference generator, wherein the voltage regulator provides a power signal corresponding to the voltage regulator reference; a compensation block coupled to the input terminal to provide a modulation control signal based on the input signal; a modulator coupled to the compensation block wherein the modulator provides a modulated signal in response to the modulation control signal; and an output stage coupled to the modulator and the voltage regulator, wherein the output stage provides an output signal at the output terminal by combining the modulated signal and the power signal.

US 2009/0220110 A1 discloses a system and method of improving the efficiency in the power consumption of an audio system. In essence, the technique is to adjust the power delivered from the power supply to the analog section, such as the power amplifier, in response to the volume level indicated by the volume control module and/or in response to the detected characteristic of the input audio signal. Thus, in this manner, the analog section is operated in a manner that is related to the level of the signal it is processing. Additionally, the system and method also relate to a technique of adjusting the dynamic ranges of the digital signal and the analog signal to improve the overall dynamic range of the system without needing to consume additional power.

US 5,510,753 discloses a composite bridge amplifier having four output transistors in a bridge configuration. The transistor control terminals (gates or bases) are controlled by an input signal which is amplified in a phase splitter and voltage gain stage. The output terminals of the transistors receive a power signal which varies with the input signal at a level sufficient to maintain headroom above the output signal but to reduce power dissipation in the transistors. The power signal is produced by a switch connected between a floating power supply and a filter and operated at e.g. 200 kHz. The switch is operated by a pulse width modulated (pwm) signal derived from the absolute value of the input signal. A proportional integral controller is coupled between the filter output and the pulse width modulator for closed loop feedback. The output is aligned with the input signal by phase shifter connected to the controller.

### Summary of Invention

### Technical Problem

However, the conventional amplifiers have the following problems.

That is, in the technique described in PTL 1, the source voltage is controlled using a value obtained by adding a fixed headroom to a value which is obtained by multiplying the absolute value of an input signal by a constant. However, when the fixed headroom is set to be low in advance and the input signal varies rapidly, the source voltage of the power amplifier stage does not follow the variation of the input signal and causes distortion of an output signal of the power amplifier stage. In addition, when the fixed headroom is set to be high on the assumption of a rapid variation of the input signal, there is a problem in that the power efficiency of the power source degrades.

As described in JP-T-2007-511187, a supply voltage signal may be created on the basis of a fixed slew rate of the voltage-variable power source to control the source voltage of the power amplifier stage. In this case, when the slew rate of the voltage-variable power source varies with a variation in load current and the slew rate of the voltage-variable power source is changed to a low value, there is a problem in that the output voltage of the voltage-variable power source does not respond to the supply voltage signal and distortion is caused in the output signal of the power amplifier stage.

Therefore, the invention is made to solve the above-mentioned problems and it is an object thereof is to provide an amplifier which can control a source voltage to follow an input signal, in which it is possible to reduce a degradation in power efficiency by changing the headroom added to the source voltage to follow the input signal.

### Solution to Problem

In order to achieve this object of the invention, there is provided an amplifier amplifying an input audio signal input to the amplifier and outputting an audio, including: a signal delay processing unit that outputs the input audio signal with a time delay; an amplifier unit that amplifies the signal output from the signal delay processing unit; a voltage-variable power source that supplies power to the amplifier unit; an envelope creating unit that creates an envelope of the input audio signal from the input audio signal; and a source voltage control unit that outputs a source voltage control signal to the voltage-variable power source on the basis of the envelope created by the envelope creating unit and controls an output voltage of the voltage-variable power source, wherein the source voltage control unit sets headroom on the basis of a signal level of the envelope, creates the source voltage control signal by adding the set headroom to the signal level of the envelope, and outputs the created source voltage control signal to the voltage-variable power source.

### Advantageous Effects of Invention

According to the invention, since an audio signal output from the amplifier is not distorted in spite of a rapid increase in amplitude of an input audio signal from the vicinity of 0 and the headroom added to the source voltage can be reduced compared to conventional amplifiers as the amplitude of the input audio signal increases, it is possible to provide an amplifier which can reduce noise superimposed on an output signal and enhance power efficiency.

### Brief Description of Drawings

Fig. 1 is a block diagram illustrating a signal-following power amplifier according to an example not falling under the scope of the claimed invention.
Fig. 2 is a flowchart of a signal delay processing unit 13 according to the example not falling under the scope of the claimed invention.
Fig. 3 is a flowchart of a simple envelope creating unit 10 according to example not falling under the scope of the claimed invention.
Fig. 4 is a diagram illustrating an example of a simple envelope according to the example not falling under the scope of the claimed invention.
Fig. 5 is a flowchart of a slope comparison processing unit 112 according to the example not falling under the scope of the claimed invention.
Fig. 6 is a diagram illustrating an example of an inter-dot slope and an inter-dot delay time in the simple envelope according to example not falling under the scope of the claimed invention.
Fig. 7 is a flowchart of a total delay time calculating unit 113 according to the example not falling under the scope of the claimed invention.
Fig. 8 is a flowchart of a voltage control signal creating unit 114 according to the first embodiment of the invention.
Fig. 9 is a diagram illustrating an example of a voltage control signal according to the example not falling under the scope of the claimed invention.
Fig. 10 is a block diagram illustrating a signal-following power amplifier according to an embodiment of the invention.
Fig. 11 is a flowchart of a headroom calculating unit 212 according to the invention.
Fig. 12 is a flowchart of a voltage control signal creating unit 213 according to the invention.
Fig. 13 is a diagram illustrating an example of a voltage control signal according to the invention.

### Description of Embodiments

Hereinafter, an amplifier according to an example not falling under the scope of the claimed invention will be described with reference to accompanying drawings.

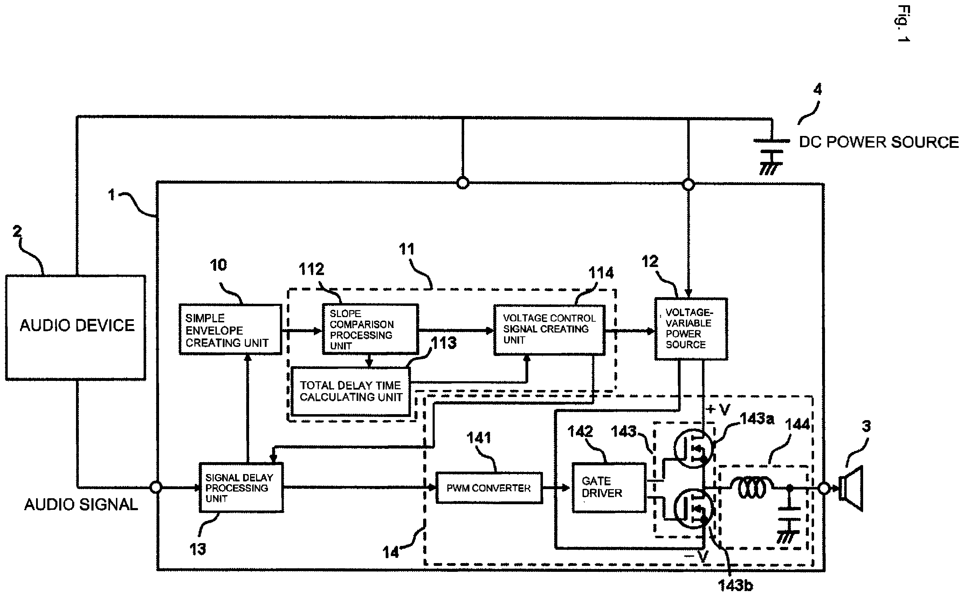

Fig. 1 is a block diagram illustrating the functions of the amplifier according to the example.

In Fig. 1, the amplifier 1 is connected to an audio device 2 outputting an audio signal of about a line level.

The audio signal output from the audio device 2 is input as an input audio signal to the amplifier 1 and the power thereof is amplified by the amplifier 1, and the resultant signal is output to a speaker 3. The speaker 3 converts the input audio signal, which is supplied from the amplifier 1 and the power of which is amplified, into a sound and radiates the sound.

The amplifier 1 and the audio device 2 are connected to a DC power source 4 supplying power necessary for operating them. Here, the power source necessary for operating the devices is not limited to DC power source, but AC power source may be appropriately used depending on characteristics of the devices.

The audio device 2 and the amplifier 1 are collectively referred to as an audio output apparatus and the audio output apparatus and the speaker 3 are collectively referred to as an audio system.

The amplifier 1 includes a simple envelope creating unit 10 as an envelope creating unit, a source voltage control unit 11, a voltage-variable power source 12, a signal delay processing unit 13, and an amplifier unit 14 as a power amplifier stage.

When an audio signal is input to the amplifier 1 from the audio device 2, the input audio signal is input to the signal delay processing unit 13.

The signal delay processing unit 13 holds the input audio signal input to the amplifier 1 for a predetermined time every predetermined sampling period, and outputs the input audio signal of the predetermined sampling period to the simple envelope creating unit 10.

The signal delay processing unit 13 outputs the input audio signal of the predetermined sampling period held in the signal delay processing unit 13 to the amplifier unit 14 at the time at which a timing signal as a predetermined control signal is input from the source voltage control unit 11 of which details will be described later. That is, the time until the timing signal is input after the input audio signal is input to the signal delay processing unit 13 corresponds to the predetermined time.

The simple envelope creating unit 10 creates a simple envelope to be described later from the input audio signal of the predetermined sampling period input from the signal delay processing unit 13, and outputs information indicating the created simple envelope (simple envelope information) to the source voltage control unit 11.

The source voltage control unit 11 creates a voltage control signal on the basis of the simple envelope information input from the simple envelope creating unit 10 and controls the output voltage of the voltage-variable power source 12.

The voltage-variable power source 12 is a power source varying the output voltage to an arbitrary voltage value in response to the voltage control signal input from the source voltage control unit 11 and supplies the power (power source) of the output voltage value based on the voltage control signal to the amplifier unit 14.

The amplifier unit 14 is a D-class amplifier and serves to amplify the input audio signal of the predetermined sampling period input from the signal delay processing unit 13 with a degree of amplification A using the power supplied from the voltage-variable power source 12 and to output the amplified input audio signal to the speaker 3 connected to the amplifier 1.

Here, the source voltage control unit 11 can be embodied by a digital signal processor or a micro controller. The simple envelope creating unit 10 and the signal delay processing unit 13 can be embodied by a digital signal processor or a micro controller.

Therefore, two or more of the source voltage control unit 11, the simple envelope creating unit 10, and the signal delay processing unit 13 may be embodied by a single digital signal processor or a micro controller.

The detailed operation of the amplifier 1 having the above-mentioned configuration will be described below.

When an audio signal is input from the audio device 2 to the amplifier 1, the input audio signal is input to the signal delay processing unit 13.

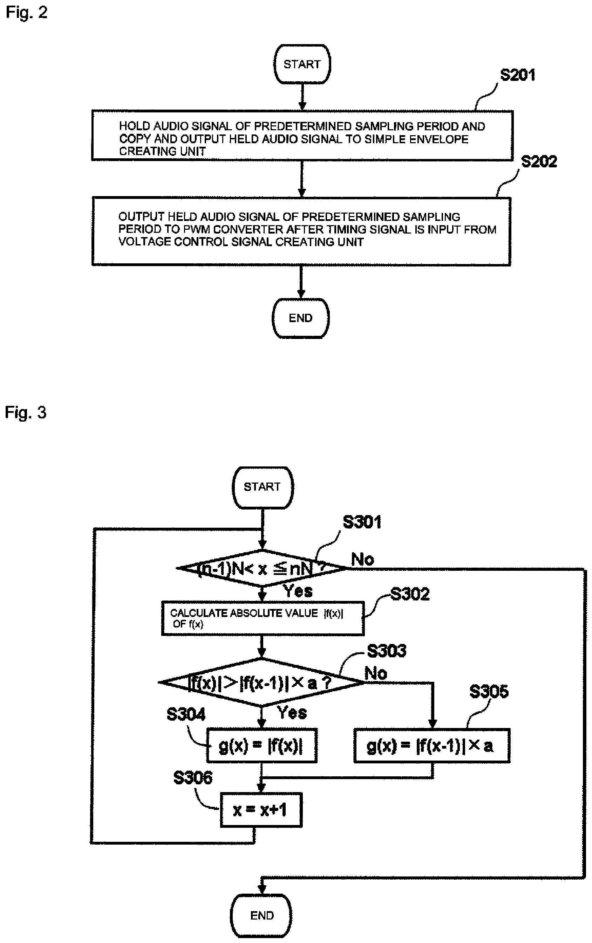

The flow of processes in the signal delay processing unit 13 will be described with reference to the flowchart shown in Fig. 2.

The signal delay processing unit 13 holds the input audio signal which is input for a predetermined time in a buffer circuit every predetermined sampling period, copies the input audio signal, and outputs the copied input audio signal of the predetermined sampling period to the simple envelope creating unit 10 (step S201).

The predetermined sampling period is a period of time defined by N digital audio signals sampled, for example, with a frequency of 44.1 kHz. Here, N is an integer.

When a timing signal (details of which will be described later) is input from the source voltage control unit 11, the signal delay processing unit 13 outputs the held input audio signal of the predetermined sampling period to the amplifier unit 14 (step S202).

Two paths of the input audio signal and the process of adjusting the timing of a signal in the two paths will be sequentially described below. A first signal path sequentially includes the signal delay processing unit 13, the amplifier unit 14, and the speaker 3. A second signal path sequentially includes the signal delay processing unit 13, the simple envelope creating unit 10, the source voltage control unit 11, and the voltage-variable power source 12.

First, the first signal path will be described with reference to the block diagram shown in Fig. 1.

The input audio signal of the predetermined sampling period input from the signal delay processing unit 13 is input to the amplifier unit 14.

The amplifier unit 14 includes a PWM converter 141, a gate driver 142, a half bridge circuit 143, and a low-pass filter 144.

The PWM converter 141 converts the input audio signal of the predetermined sampling period which is input into a PWM signal and outputs the PWM signal. A Δ∑ conversion method, a triangular wave comparison method, and the like are known as the PWM conversion method, and any of these methods can be used in this example.

The PWM signal output from the PWM converter 141 is input to the gate driver 142.

The gate driver 142 inserts a dead time into the input PWM signal, creates a drive signal obtained by shifting the potential of the PWM signal to such an extent to drive high-side and low-side high-speed switching elements 143a and 143b of the half bridge circuit 143, and outputs the drive signal to the half bridge circuit 143.

The half bridge circuit 143 includes a high-side high-speed switching element 143a that is disposed on a high-potential power source side and that is supplied with a positive voltage from the voltage-variable power source 12 and a low-side high-speed switching element 143b that is disposed on a low-potential power source (or ground) side and that is supplied with a negative voltage from the voltage-variable power source 12.

The half bridge circuit 143 performs a switching operation based on the voltage amplitude determined by a positive voltage value and a negative voltage value in response to the drive signal input from the gate driver 142, and creates an output PWM signal. An example of the high-speed switching element is a MOS field effect transistor.

The output PWM signal created through the switching operation of the half bridge circuit 143 is filtered by the low-pass filter 144, whereby the output PWM signal is converted into an analog audio signal and is then output to the speaker 3.

Then, the second signal path will be described. In the second signal path, when the input audio signal is input to the simple envelope creating unit 10 from the signal delay processing unit 13, the simple envelope creating unit 10 performs the following processes.

The operation of the simple envelope creating unit 10 will be described below with reference to the flowchart shown in Fig. 3.

The simple envelope creating unit 10 creates a simple envelope for the input audio signal of the predetermined sampling period input from the signal delay processing unit 13. Examples of the envelope creating method include known methods such as a maximum value holding method and a band-limiting method using an LPF. A simple envelope created using a simple method is exemplified herein.

In describing the operation of the simple envelope creating unit 10, x, N, and n are treated as integers and x is treated as a time. Each digital signal of the input audio signal is defined by data f(x) of time x, each digital signal in the created simple envelope is defined by data g (x) of time x, the predetermined sampling period including data of successive N points is defined as 1 frame, and the frames are processed as the n-th frame in the input order thereof.

The simple envelope creating unit 10 determines whether x in the n-th frame of the input audio signal of the predetermined sampling period which is input satisfies (n-1)N<x≤nN (step S301), and calculates the absolute value |f(x)| of the input audio signal f (x) when it is determined that x satisfies (n-1)N<x≤nN (step S302).

Then, the calculated |f(x)| is compared with a value obtained by multiplying the previous value |f(x-1)| by a coefficient a (step S303), and the larger value is set as the simple envelope g(x) (steps S304 and S305). Then, x is updated (step S306).

Here, the coefficient a is a value used to determine the falling slope of the simple envelope g(x) and is determined from the falling slew rate of the output voltage when the load current in the voltage-variable power source 12 is the smallest.

Since |f(x)| is always selected in the rise of the input audio signal f(x) through the processes of steps S303, S304, and S305, the simple envelope g(x) rises along the vicinity of the input audio signal f(x).

In the fall of the input audio signal f(x), when the falling slope of the input audio signal f(x) is greater than the coefficient a, the simple envelope g(x) falls along the vicinity of the coefficient a. When the falling slope of the input audio signal f (x) is smaller than the coefficient a, the simple envelope g (x) falls along the vicinity of the input audio signal f(x).

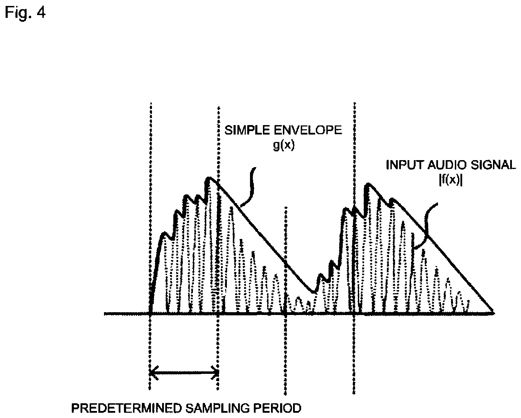

An example of the created simple envelope is shown in Fig. 4. A waveform expressed by a successive set of discrete digital signals is shown as an analog waveform in which the discrete digital signals are connected for the purpose of convenience in Fig. 4.

By processing the input audio signal of the predetermined sampling period which is input as described above, the simple envelope creating unit 10 can obtain digital signals forming a waveform in which the rise is in the vicinity of |f(x)| and the fall is in the vicinity of the coefficient a, as indicated by the simple envelope g(x) in Fig. 4.

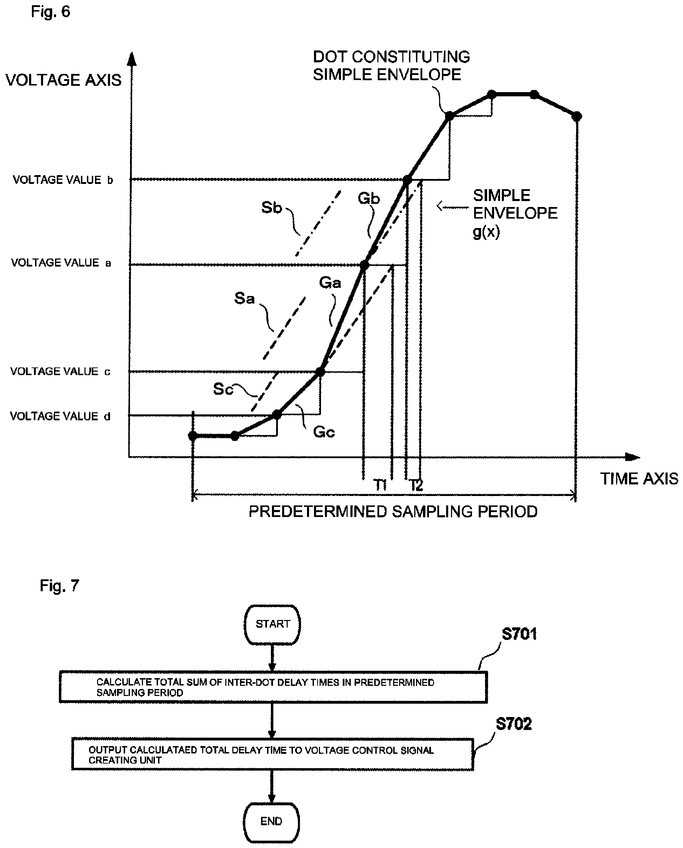

The simple envelope is constructed by a successive set of discrete digital signals as shown in Fig. 6. The respective digital signals are defined as a dot. An inter-dot slope is calculated by an expression of "voltage value/time value" on the basis of the voltage value (vertical axis) of two successive dots and the time value (horizontal axis) calculated from the reciprocal of an inter-dot period used to calculate the simple envelope.

The digital signals (simple envelope information) forming the simple envelope g (x) created by the simple envelope creating unit 10 is output to the source voltage control unit 11.

The source voltage control unit 11 creates a voltage control signal from the simple envelope information input from the simple envelope creating unit 10 as described below and outputs the created voltage control signal to the voltage-variable power source 12.

As shown in Fig. 1, the source voltage control unit 11 includes a slope comparison processing unit 112, a total delay time calculating unit 113, and a voltage control signal creating unit 114. The simple envelope input from the simple envelope creating unit 10 is first input to the slope comparison processing unit 112.

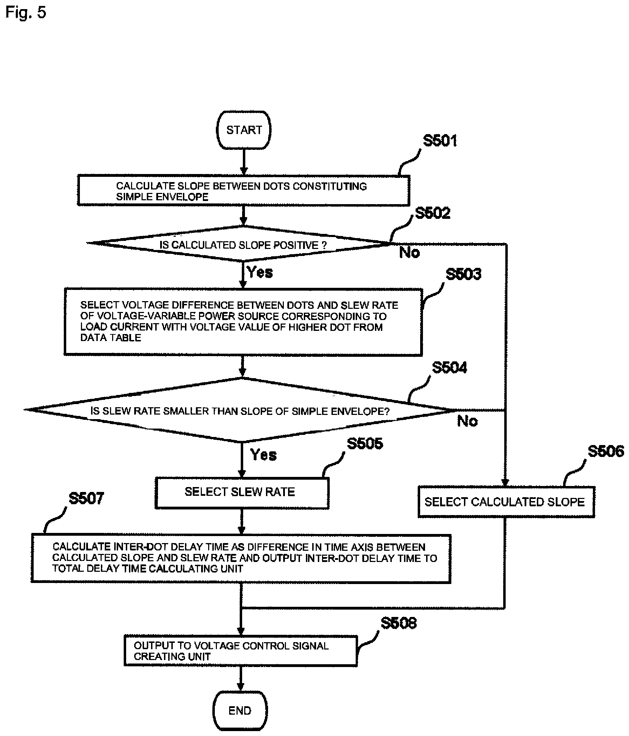

The flow of processes in the slope comparison processing unit 112 will be described below with reference to the flowchart shown in Fig. 5.

The slope comparison processing unit 112 first calculates the inter-dot slope of the dots defined by the digital signals forming the input simple envelope (step S501).

The inter-dot slope is calculated from the coordinate values in the voltage axis and the time axis of the anteroposterior dots. When the calculated slope is not positive, the calculated slope is output to the voltage control signal creating unit 114 (steps S502, S506, and S508).

When the calculated slope is positive, the slew rate, which corresponds to the difference in the voltage axis between the dots and the current value flowing in a load with the voltage value of the higher dot, of the voltage-variable power source 12 is selected from a data table (step S503).

Here, the data table includes voltage difference values between dots, a load current value with the voltage value of the higher dot, and the slew rate of the voltage-variable power source 12 corresponding to the two values and is stored in the slope comparison processing unit 112 in advance. Next, the slope calculated from the simple envelope is compared with the selected slew rate of the voltage-variable power source 12 (step S504).

When the slew rate is not smaller than the calculated slope, the calculated slope is selected and this value is output to the voltage control signal creating unit 114 (steps S506 and S508).

When the slew rate is smaller than the calculated slope, the slew rate is selected (step S505), an inter-dot delay time, which is a difference value in the time axis direction between the calculated slope and the slew rate, is calculated, this information is output to the total delay time calculating unit 113 (step S507), and the slew rate is output to the voltage control signal creating unit 114 (step S508).

The inter-dot delay time is calculated as follows (see Fig. 6). First, a difference value in the voltage axis between two dots and a slew rate of the voltage-variable power source 12 corresponding to the load current value with the voltage value of the higher dot are selected from the data table.

Then, a difference in the time axis direction between the inter-dot slope of the simple envelope and the slew rate of the voltage-variable power source 12 when the voltage value varies from the lower dot of two dots to the higher dot is calculated. In this example, this difference is defined as the inter-dot delay time.

When the inter-dot slope of the simple envelope is greater than the selected slew rate of the voltage-variable power source 12, the inter-dot delay time is generated.

For example, as shown in Fig. 6, when dots of a voltage value d, a voltage value c, a voltage value a, and a voltage value b sequentially from the low voltage side in the simple envelope g(x) are considered, the inter-dot delay time is calculated as follows.

That is, the inter-dot voltage difference (voltage value c-voltage value d) between the voltage value d and the voltage value c and the slew rate Sc corresponding to the load current when the voltage value of the higher dot (the voltage value c is the voltage value of the higher dot in this case) are applied to a load are selected from the data table, and the selected slew rate Sc and the inter-dot slope Gc between the voltage value d and the voltage value c are compared with each other. In this case, since the selected slew rate Sc is greater, the inter-dot delay time is not generated.

The inter-dot voltage difference (voltage value a-voltage value c) between the voltage value c and the voltage value a and the slew rate Sa corresponding to the load current when the voltage value of the higher dot (the voltage value a is the voltage value of the higher dot in this case) are applied to a load are selected from the data table, and the selected slew rate Sa and the inter-dot slope Ga between the voltage value c and the voltage value a are compared with each other. In this case, since the selected slew rate Sa is smaller, the inter-dot delay time T1 is generated.

Similarly, the inter-dot voltage difference (voltage value b-voltage value a) between the voltage value a and the voltage value b and the slew rate Sb corresponding to the load current when the voltage value of the higher dot (the voltage value b is the voltage value of the higher dot in this case) are applied to a load are selected from the data table, and the selected slew rate Sb and the inter-dot slope Gb between the voltage value a and the voltage value b are compared with each other. In this case, since the selected slew rate Sb is smaller, the inter-dot delay time T2 is generated.

The total delay time in a predetermined sampling period is the total sum of the inter-dot delay times. In Fig. 6, a delay time is generated between the dots of the voltage value c and the voltage value a and between the dots of the voltage value a and the voltage value b, and "T1+T2" is calculated as the total delay time.

The operation of the slope comparison processing unit 112 is performed on the dots of the input audio signal of the predetermined sampling period.

The total delay time calculating unit 113 to which the inter-dot delay time information is input performs the following processes.

The flow of processes in the total delay time calculating unit 113 will be described below with reference to the flowchart shown in Fig. 7.

The total delay time calculating unit 113 holds the inter-dot delay times input from the slope comparison processing unit 112 and calculates the total sum of the inter-dot delay times in a predetermined sampling period (step S701). The calculated total delay time is output to the voltage control signal creating unit 114 (step S702).

The voltage control signal creating unit 114 having received the inter-dot slope and the slew rate from the slope comparison processing unit 112 performs the following processes.

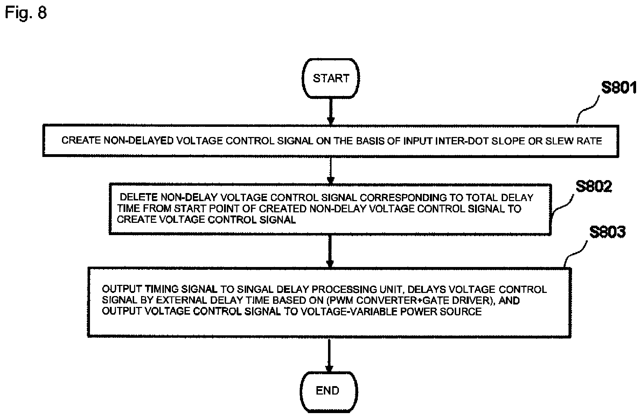

The flow of processes in the voltage control signal creating unit 114 will be described below with reference to the flowchart shown in Fig. 8.

The voltage control signal creating unit 114 creates a non-delayed voltage control signal on the basis of the inter-dot slope input from the slope comparison processing unit 112 or the slew rate of the voltage-variable power source 12 (step S801).

Then, the non-delayed voltage control signal corresponding to the total delay time input from the total delay time calculating unit 113 from the start point of the non-delayed voltage control signal is deleted and a voltage control signal is created(step S802).

A timing signal is output to the signal delay processing unit 13 and the voltage control signal is delayed by an external delay time from the output of the timing signal and is then output to the voltage-variable power source 12 (step S803). The external delay time is the width of a delay time generated by the PWM converter 141 and the gate driver 142.

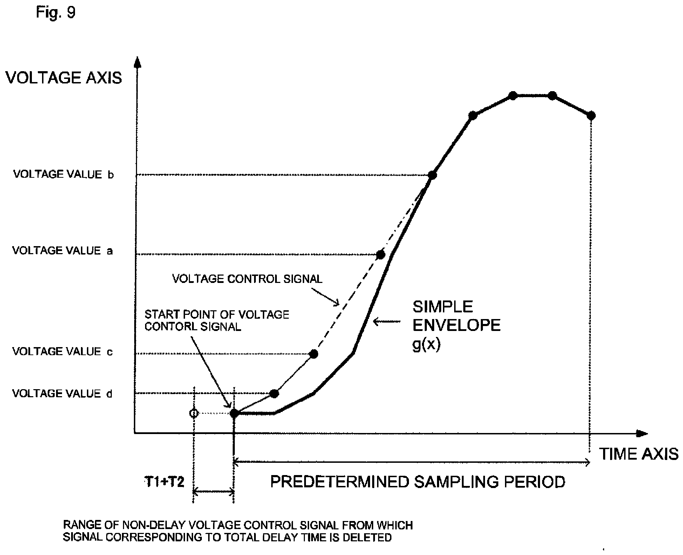

An example of the voltage control signal created by the voltage control signal creating unit 114 will be described below with reference to Fig. 9. A waveform expressed by a successive set of discrete digital signals is shown as an analog waveform in which the discrete digital signals are connected for the purpose of convenience in Fig. 9.

The voltage control signal creating unit 114 creates the voltage control signal as follows. First, the inter-dot slopes in the input simple envelope or the slew rates of the voltage-variable power source 12 are continuously connected to create a non-delayed voltage control signal.

The non-delayed voltage control signal is a signal expressed by a waveform in which the voltage control signal and the voltage control signal corresponding to the total delay time "T1+T2" connected before the start point of the voltage control signal are added in the drawing. Then, the non-delayed voltage control signal corresponding to the total delay time "T1+T2" from the start point of the non-delayed voltage control signal is deleted. In this way, a voltage control signal of the same period as the predetermined sampling period is created as shown in the drawing.

The voltage-variable power source 12 outputs a positive source voltage and a negative source voltage using the value of the voltage control signal from the voltage control signal creating unit 114 as a voltage target value.

The positive source voltage is supplied to the high-side high-speed switching element 143a disposed on the high-potential power source side of the half bridge circuit 143 in the amplifier unit 14.

The negative source voltage is supplied to the low-side high-speed switching element 143b disposed on the low-potential power source side of the half bridge circuit 143 in the amplifier unit 14.

The process of adjusting the timing of two signal paths will be described below with reference to the block diagram shown in Fig. 1.

The signal delay processing unit 13 delays the output of the input audio signal to the amplifier unit 14 by holding the input audio signal until a timing signal is input from the voltage control signal creating unit 114 after the input audio signal is output to the simple envelope creating unit 10.

When the voltage control signal creating unit 114 outputs the voltage control signal, the output of the voltage control signal is delayed by the external delay time, which is the sum of the delay times in the PWM converter 141 and the gate driver 142, from the output of the timing signal.

That is, the delay process of the signal delay processing unit 13 and the delay process performed at the time of outputting the voltage control signal from the voltage control signal creating unit 114 are used to adjust the time until the input audio signal is processed by the amplifier 14 and reaches the half bridge circuit 143 and the time until the input audio signal is processed by the source voltage control unit 11 and power is supplied to the half bridge circuit 143 from the voltage-variable power source 12.

In this way, since the timing of inputting the audio signal (input audio signal) input from the outside of the amplifier 1 to the amplifier 14 is adjusted, the source voltage of the amplifier 1 is controlled to appropriately follow a variation in level of the input audio signal.

As described above, the invention includes the source voltage control unit 11 creating a voltage control signal from a simple envelope of an input audio signal to control the voltage-variable power source 12. The source voltage control unit 11 includes the slope comparison processing unit 112 calculating the slope necessary for creating the voltage control signal, the total delay time calculating unit 113 calculating the total sum of the inter-dot delay times generated through the slope comparing process, and the voltage control signal creating unit 114 creating the voltage control signal so that the waveform formed by the voltage control signal controlling the voltage-variable power source 12 should be a waveform reflecting the selected slope or slew rate and the total delay time. The voltage control signal is adjusted to match with the timing at which the input audio signal is amplified by the amplifier unit 14, and is then output to the voltage-variable power source 12.

Accordingly, by comparing the slew rate corresponding to the load current of the voltage-variable power source 12 with the inter-dot slope in the simple envelope of the input audio signal and reflecting the selected slope or slew rate and the total delay time in the voltage control signal as described above, it is possible to cope with the slew rate corresponding to the load current even when the load current of the voltage-variable power source 12 varies. By supplying the output voltage of the voltage-variable power source 12 controlled on the basis of the voltage control signal to the amplifier unit 14, the audio signal is not distorted in the amplifier unit 14 and it is possible to keep the power efficiency high.

Hereinafter, an amplifier according to an embodiment of the claimed invention will be described with reference to accompanying drawings.

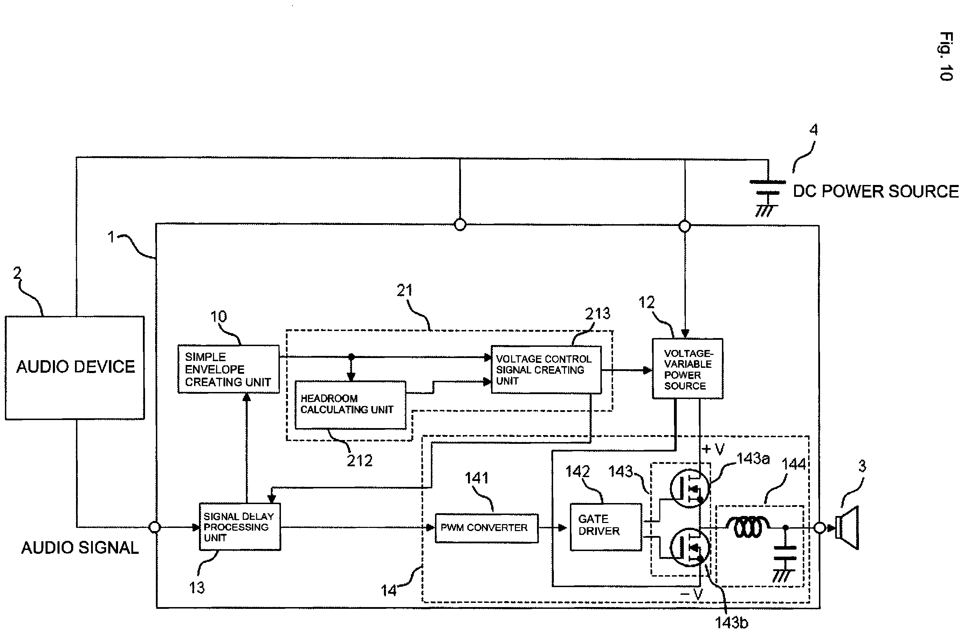

Fig. 10 is a block diagram illustrating the functions of the amplifier according to the embodiment of the invention.

In this embodiment, a voltage source control unit 21 is provided instead of the source voltage control unit 11 as provided in the above-described example. The voltage source control unit 21 includes a headroom calculating unit 212 and a voltage control signal creating unit 213. The other configuration is the same as in the above-described exmaple and thus the configuration and operation thereof will not be described. Hereinafter, the configuration and operation in this embodiment according to the claimed invention will be described on the basis of the features of this embodiment.

The amplifier 1 according to the claimed invention changes the value of a source voltage (set and apply the source voltage lowering the source voltage when the input audio signal is relatively low, and raising the source voltage when the input audio signal is relatively high) which is supplied to the amplifier 14 from the voltage-variable power source 12 to correspond to the variation in level (signal level of an envelope) of an input audio signal input to the amplifier 1.

When the "headroom" to be described below is not considered, the amplitude of an audio signal output from the amplifier 1 may become greater than the voltage value supplied from the voltage-variable power source 12 and the audio signal output from the amplifier 1 would be distorted, possibly.

To what extent the source voltage output from the voltage-variable power source 12 can follow the voltage control signal input to the voltage-variable power source 12 is determined depending on the capabilities (such as the slew rate of the voltage-variable power source and the minimum output voltage) of the voltage-variable power source 12.

Accordingly, the source voltage output from the voltage-variable power source 12 needs to have a margin with respect to the amplitude of the audio signal output from the amplifier 1. In the following description, the margin is referred to as headroom.

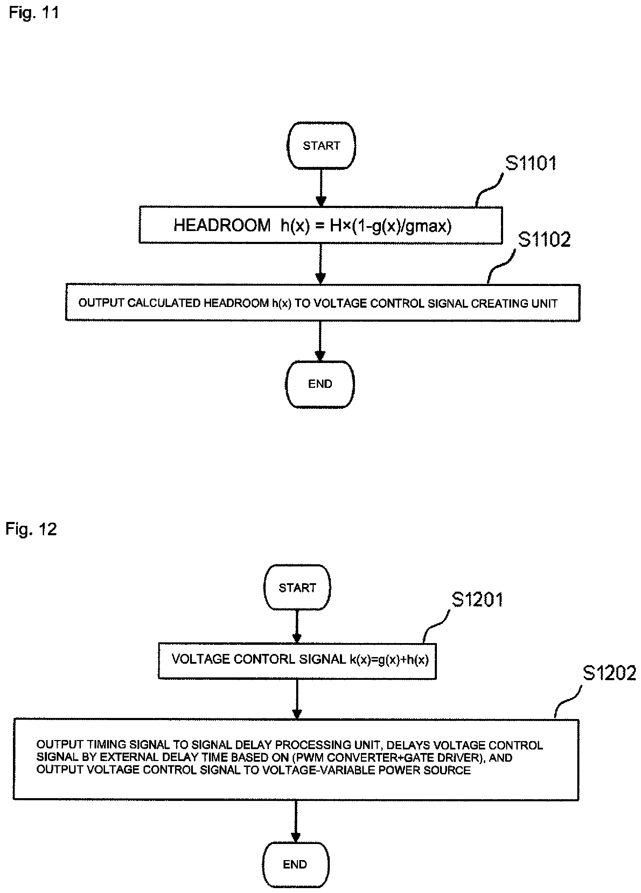

As shown in Fig. 11, the voltage source control unit 21 includes the headroom calculating unit 212 and the voltage control signal creating unit 213. The simple envelope information input from the simple envelope creating unit 10 is input to the headroom calculating unit 212 and the voltage control signal creating unit 213.

The flow of processes in the headroom calculating unit 212 will be described below with reference to the flowchart shown in Fig. 11.

The headroom calculating unit 212 calculates headroom h(x) from a simple envelope g(x) at a time x input from the simple envelope creating unit 10, the maximum value gmax of the simple envelope g(x), and the maximum value H of the headroom by the use of an expression h (x) =Hx (1-g (x) /gmax) (step S1101).

In this embodiment of the invention, the process of calculating the headroom depending on the signal level of the envelope means a process of calculating the headroom h(x) through the use of the above-mentioned expression.

Here, the maximum value gmax of the simple envelope is a value determined in advance from the degree of amplification A of the amplifier 14 through the use of the following expression, when the maximum voltage value output from the voltage-variable power source 12 is defined as Vmax and the output audio signal output from the amplifier 1 is controlled not to be a voltage value greater than or equal to Vmax. The expression is gmax=Vmax/A.

The maximum value H of the headroom is expressed as H=Vmin/A from the minimum voltage value Vmin output from the voltage-variable power source 12.

The headroom calculating unit 212 outputs the calculated headroom h(x) to the voltage control signal creating unit 213 (step S1102).

The flow of processes in the voltage control signal creating unit 213 will be described below with reference to the flowchart shown in Fig. 12.

The voltage control signal creating unit 213 creates a value, which is obtained by adding the simple envelope g(x) input from the simple envelope creating unit 10 and the headroom h(x) input from the headroom calculating unit 212, as a voltage control signal k(x) (step S1201).

A timing signal is output to the signal delay processing unit 13 and the voltage control signal k(x) is delayed by the external delay time from the output of the timing signal and is output to the voltage-variable power source 12 (step S1202) . The external delay time means the width of a delay time generated in the PWM converter 141 and the gate driver 142.

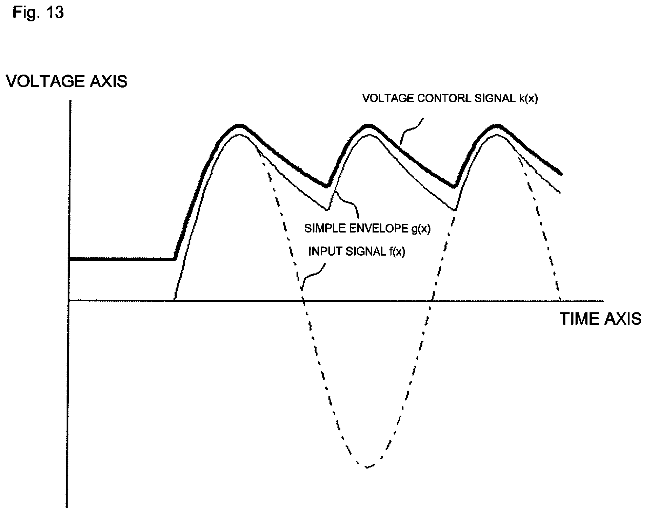

An example of the created voltage control signal created by the voltage control signal creating unit 213 will be described below with reference to Fig. 13. A waveform expressed by a successive set of discrete digital signals is shown as an analog waveform in which the discrete digital signals are connected for the purpose of convenience in Fig. 13.

As shown in Fig. 13, the simple envelope g(x), related to the input audio signal f(x), rises along the vicinity of the input audio signal f(x) and falls along the vicinity of the coefficient a.

In the voltage control signal k(x), the headroom h(x) is added to the simple envelope g(x). As can be seen from the expression of the headroom h(x), the headroom h(x) takes the maximum value H when the simple envelope g(x) is 0, and the headroom h(x) takes 0.7xH when the simple envelope g(x) is 0.3×gmax.

Accordingly, Fig. 13 shows a wave form where the headroom h(x) takes H when the level of the input audio signal is 0, and as the level of the input audio signal increases from 0, the headroom h(x) becomes smaller than H.

In the above description, the headroom is set from the calculation result using the signal level of an envelope when setting the headroom corresponding to the signal level of the envelope. However, the magnitudes (value or information indicating the value) of the headroom corresponding to the signal level of the envelope may be stored as a data table in advance and the magnitude of the headroom corresponding to the "detected signal level of the envelope" may be read from the data table to set the headroom when the signal level of the envelope is detected.

As described above, the invention includes the source voltage control unit 21 creating a voltage control signal from a simple envelope of an input audio signal to control the voltage-variable power source 12. The source voltage control unit 21 includes the headroom calculating unit 212 calculating the headroom necessary for creating the voltage control signal and the voltage control signal creating unit 213 creating the voltage control signal used to control the voltage-variable power source 12. The voltage control signal creating unit 213 performs the process of adding the headroom, which is calculated depending on the signal level of the simple envelope by the headroom calculating unit 212, to the simple envelope, adjusts the voltage control signal to match with the timing at which the input audio signal is amplified by the amplifier unit 14, and then outputs the voltage control signal to the voltage-variable power source 12.

Accordingly, by changing the headroom to follow the input audio signal, when the amplitude of the input audio signal is rapidly increases from the vicinity of 0, the voltage control signal k(x) has a margin of about the maximum headroom H with respect to the input audio signal and thus the voltage value supplied to the amplifier unit 14 from the voltage-variable power source 12 is not lower than the amplitude of the audio signal output from the amplifier unit 14. Since the headroom to be added to the source voltage can be reduced compared to conventional amplifiers as the amplitude of the input audio signal increases from 0, the audio signal in the amplifier unit 14 is not distorted and the power efficiency can be kept high by supplying the amplifier unit 14 with the output voltage of the voltage-variable power source 12 controlled by the voltage control signal.

### Industrial Applicability

As described above, the invention can provide an amplifier amplifying the power of an input signal, which can enhance power efficiency of the amplifier, since an audio signal output from the amplifier is not distorted in spite of a rapid increase in amplitude of an input audio signal from the vicinity of 0 by changing the headroom to follow the input audio signal and the headroom added to the source voltage can be reduced as the amplitude of the input audio signal increases. The amplifier according to the invention can be usefully used as an amplifier and the like controlling a source voltage of supply power at a power amplifier stage of a signal.

### Reference Signs List

- 1:: amplifier
- 2:: audio device
- 3:: speaker
- 4:: DC power source
- 10:: simple envelope creating unit
- 11, 21:: source voltage control unit
- 12:: voltage-variable power source
- 13:: signal delay processing unit
- 14:: amplifier unit
- 112:: slope comparison processing unit
- 113:: total delay time calculating unit
- 114, 213:: voltage control signal creating unit
- 212:: headroom calculating unit
- 141:: PWM converter
- 142:: gate driver
- 143:: half bridge circuit
- 144:: low-pass filter

## Claims

1. An amplifier (1) amplifying an input audio signal input to the amplifier (1) and outputting an audio, comprising:
a signal delay processing unit (13) that outputs the input audio signal with a time delay;
an amplifier unit (14) that amplifies the signal output from the signal delay processing unit (13);
a voltage-variable power source (12) that supplies power source to the amplifier unit (14);
an envelope creating unit (10) that creates an envelope of the input audio signal from the input audio signal; and
a source voltage control unit 21 that outputs a source voltage control signal to the voltage-variable power source (12) on the basis of the envelope created by the envelope creating unit (10) and controls an output voltage of the voltage-variable power source (12),
wherein the source voltage control unit 21 sets headroom on the basis of a signal level of the envelope, creates the source voltage control signal by adding the set headroom to the signal level of the envelope, and outputs the created source voltage control signal to the voltage-variable power source (12), and wherein
the source voltage control unit (21) outputs a timing signal to the signal delay processing unit (13), and the signal delay processing unit (13) processes the time delay based on the timing signal.

2. The amplifier (1) according to claim 1, wherein the time until the envelope creating unit (10) creates the envelope of the input audio signal and the source voltage control unit (21) adds the calculated headroom to the signal level of the envelope to create the source voltage control signal and outputs the source voltage control signal to the voltage-variable power source (12) after the input audio signal is input to the envelope creating unit (10) is equal to the time obtained by adding an external delay time which is a delay time in the amplifier unit (14) to the time delay by which the signal delay processing unit (13) delays the input audio signal.

3. An audio output apparatus comprising:
an audio device (2) that creates and outputs an input audio signal; and the amplifier (1) according to claim 1 to which the input audio signal is input.

4. An audio system comprising:
the audio output apparatus according to claim 3; and
a speaker (3) to which the output audio output from the audio output apparatus is input.

5. The amplifier (1) according to claim 1,
wherein the signal delay processing unit (13) outputs the input audio signal of a sampling period held in the signal delay processing unit (13) to the amplifier unit (14) in response to the input of the timing signal, and
wherein the source voltage control unit (21) outputs the voltage control signal, which is delayed by an external delay time from the output of the timing signal, to the voltage-variable power source (12).

## Patentansprüche

1. Verstärker (1), der ein Audio-Eingangssignal verstärkt, das in den Verstärker (1) eingegeben wird, und ein Audiosignal ausgibt, Folgendes umfassend:
eine Signalverzögerungsverarbeitungseinheit (13), die das Audio-Eingangssignal mit einer Zeitverzögerung ausgibt;
eine Verstärkereinheit (14), die das von der Signalverzögerungsverarbeitungseinheit (13) ausgegebene Signal verstärkt;
eine spannungsvariable Stromquelle (12), die der Verstärkereinheit (14) eine Stromquelle zuführt;
eine Hüllkurvenerzeugungseinheit (10), die eine Hüllkurve des Audio-Eingangssignals aus dem Audio-Eingangssignal erzeugt; und
eine Quellenspannungssteuereinheit (21), die ein Quellenspannungssteuersignal an die spannungsvariable Stromquelle (12) auf der Basis der durch die Hüllkurvenerzeugungseinheit (10) erzeugten Hüllkurve ausgibt und eine Ausgangsspannung der spannungsvariablen Stromquelle (12) steuert,
wobei die Quellenspannungssteuereinheit (21) einen Headroom auf der Basis eines Signalpegels der Hüllkurve einstellt, das Quellenspannungssteuersignal durch Addieren des eingestellten Headrooms zum Signalpegel der Hüllkurve erzeugt, und das erzeugte Quellenspannungssteuersignal an die spannungsvariable Stromquelle (12) ausgibt, und wobei
die Quellenspannungssteuereinheit (21) ein Zeitsignal an die Signalverzögerungsverarbeitungseinheit (13) ausgibt, und die Signalverzögerungsverarbeitungseinheit (13) die Zeitverzögerung basierend auf dem Zeitsignal verarbeitet.

2. Verstärker (1) nach Anspruch 1, wobei die Zeit, bis die Hüllkurvenerzeugungseinheit (10) die Hüllkurve des Audio-Eingangssignals erzeugt und die Quellenspannungssteuereinheit (21) den berechneten Headroom zum Signalpegel der Hüllkurve addiert, um das Quellenspannungssteuersignal zu erzeugen, und das Quellenspannungssteuersignal an die spannungsvariable Stromquelle (12) ausgibt, nachdem das Audio-Eingangssignal in die Hüllkurvenerzeugungseinheit (10) eingegeben ist, der Zeit gleicht, die durch Addieren einer externen Verzögerungszeit erhalten wird, welches eine Verzögerungszeit zu der Zeitverzögerung in der Verstärkereinheit (14) ist, mit der die Signalverzögerungsverarbeitungseinheit (13) das Audio-Eingangssignal verzögert.

3. Audioausgabevorrichtung, Folgendes umfassend:
eine Audiovorrichtung (2), die ein Audio-Eingangssignal erzeugt und ausgibt; und
den Verstärker (1) nach Anspruch 1, in den das Audio-Eingangssignal eingegeben wird.

4. Audiosystem, Folgendes umfassend:
die Audioausgabevorrichtung nach Anspruch 3; und
einen Lautsprecher (3), in den die von der Audioausgabevorrichtung ausgegebene Audioausgabe eingegeben wird.

5. Verstärker (1) nach Anspruch 1,
wobei die Signalverzögerungsverarbeitungseinheit (13) das Audio-Eingangssignal einer Abtastperiode, gehalten in der Signalverzögerungsverarbeitungseinheit (13), als Reaktion auf die Eingabe des Zeitsignals an die Verstärkereinheit (14) ausgibt, und
wobei die Quellenspannungssteuereinheit (21) das Spannungssteuersignal, das um eine externe Verzögerungszeit von der Ausgabe des Zeitsignals verzögert ist, an die spannungsvariable Stromquelle (12) ausgibt.

## Revendications

1. Amplificateur (1) amplifiant un signal audio d'entrée entré dans l'amplificateur (1) et délivrant un signal audio, comprenant:
une unité de traitement de retard de signal (13) qui délivre le signal audio d'entrée avec un retard temporel;
une unité d'amplification (14) qui amplifie le signal délivré par l'unité de traitement de retard de signal (13);
une source de courant à tension variable (12) qui fournit une source de courant à l'unité d'amplification (14);
une unité de création d'enveloppante (10) qui crée une enveloppante du signal audio d'entrée à partir du signal audio d'entrée; et
une unité de commande de tension de source (21) qui délivre un signal de commande de tension de source à la source de courant à tension variable (12) sur la base de l'enveloppante créée par l'unité de création d'enveloppante (10) et commande une tension de sortie de la source de courant à tension variable (12),
dans lequel l'unité de commande de tension de source (21) règle un headroom sur la base d'un niveau de signal de l'enveloppante, crée le signal de commande de tension de source en additionnant ledit headroom réglé au niveau de signal de l'enveloppante, et délivre le signal de commande de tension de source à la source de courant à tension variable (12), et dans lequel
l'unité de commande de tension de source (21) délivre un signal horaire à l'unité de traitement de retard de signal (13), et l'unité de traitement de retard de signal (13) traite le retard temporel sur la base du signal horaire.

2. Amplificateur selon la revendication 1, dans lequel le temps jusqu'à ce que l'unité de création d'enveloppante (10) crée l'enveloppante du signal audio d'entrée et l'unité de commande de tension de source (21) additionne le headroom calculé au niveau de signal de l'enveloppante pour créer le signal de commande de tension de source et délivre le signal de commande de tension de source à la source de courant à tension variable (12) après avoir entré le signal audio d'entrée dans l'unité de création d'enveloppante (10) est égal au temps obtenu en additionnant un temps de retard externe qui est un temps de retard dans l'unité d'amplification (14) au retard temporel par lequel l'unité de traitement de retard de signal (13) retarde le signal audio d'entrée.

3. Dispositif de sortie audio comprenant:
un dispositif audio (2) qui crée et délivre un signal audio d'entrée; et
l'amplificateur (1) selon la revendication 1 dans lequel le signal audio d'entrée est entré.

4. Système audio comprenant:
le dispositif de sortie audio selon la revendication 3; et
un haut-parleur (3) dans lequel la sortie audio sortie par le dispositif de sortie audio est entrée.

5. Amplificateur (1) selon la revendication 1,
dans lequel l'unité de traitement de retard de signal (13) délivre le signal audio d'entrée d'une période d'échantillonnage, tenue dans l'unité de traitement de retard de signal (13), à l'unité d'amplification (14) en réponse à l'entrée du signal horaire, et
dans lequel l'unité de commande de tension de source (21) délivre, à la source de courant à tension variable (12), le signal de commande de tension qui est en retard d'un temps de retard externe par rapport à la sortie du signal horaire.
